# EUROPEAN PATENT APPLICATION

(11) **EP 4 589 048 A1**
(43) Date of publication of application: **23.07.2025**
(21) Application number: 23865919.7
(22) Date of filing: 15.09.2023
(51) Int. Cl.: C23C 16/18, C23C 16/455, C23C 16/34, C23C 16/30, C23C 16/40, C23C 16/50, H01L 21/02

(54) **PRECURSOR FOR FORMING LANTHANIDE METAL-CONTAINING THIN FILM, METHOD FOR FORMING LANTHANIDE METAL-CONTAINING THIN FILM USING SAME, AND SEMICONDUCTOR ELEMENT INCLUDING LANTHANIDE METAL-CONTAINING THIN FILM**

(30) Priority: 16.09.2022 KR 20220117161
(71) Applicant: SK Tri Chem Co., Ltd., Sejong 30068 (KR)
(72) Inventor: OH, Han Sol, Sejong 30068 (KR); KIM, Han Byul, Sejong 30068 (KR); PARK, Yong Joo, Sejong 30068 (KR); RYU, Beom Seok, Sejong 30068 (KR); LEE, Sang Kyung, Sejong 30068 (KR)
(74) Representative: dompatent von Kreisler Selting Werner - Partnerschaft von Patent- und Rechtsanwälten mbB
(86) International application number: PCT/KR2023/013986
(87) International publication number: WO 2024/058624

(57) **Abstract**

The present invention relates to: a precursor for forming a lanthanide metal-containing thin film, the precursor being characterized by comprising a compound represented by chemical formula 1; a method for forming a lanthanide metal-containing thin film using same; and a semiconductor element including the lanthanide metal-containing thin film. The precursor includes a lanthanide metal core, a cyclopentadienyl ligand providing properties such as a low melting point and high volatility, and a novel amidinate ligand that provides high structural stability, low viscosity, high volatility, high thermal stability, and properties such as being a liquid at room temperature or a solid with a low melting point. Therefore, the precursor exhibits physical properties suitable for use in a thin film formation process and thus can be used to form a high-quality thin film.

## Description

### Technical Field

The present disclosure relates to a precursor for forming a lanthanide metal-containing thin film, a method for forming a lanthanide metal-containing thin film using the same, and a semiconductor element including the lanthanide metal-containing thin film. More particularly, the present disclosure relates to a precursor for forming a lanthanide metal-containing thin film, the precursor being capable of forming a high-quality thin film by constructing a precursor with low viscosity, high thermal stability, and high volatility through a chemical structure including an amidinate ligand, to a method for forming a thin film using the same, and to a semiconductor element including the thin film.

### Background Art

With improved integration density achieved through the miniaturization of line widths in semiconductor elements, there is a limitation in the line width of a space allowed for the implementation of capacitor structures. Accordingly, there have been limitations with existing silicon-based dielectrics in manufacturing methods of semiconductor elements for implementing capacitor structures. In addition, with the application of high-dielectric thin films to replace silicon-based dielectrics, there have been problems in that the leakage current affected by bandgaps is significantly increased, resulting in degradation.

As one of the solutions to these problems, a technology for forming high-quality thin films is required, and therefor, precursors used for thin film formation need to be optimized.

In one example of precursor optimization methods in the art, various doping precursors that can improve properties, that is, improve permittivity and reduce leakage current have been proposed. However, these precursors are typically either solids or liquids with low volatility and may cause many problems in thin film formation deposition processes, especially due to the high viscosity thereof. Therefore, improving the physical properties of precursors, such as high volatility, low viscosity, and the like, is a crucial task to achieve optimization of precursors for forming thin films.

To this end, various metal-containing precursors are being developed. For example, Korean Patent Application Publication No. 10-2019-0008427 has disclosed a lanthanide metal-containing precursor including an aza-allyl ligand, and Korean Patent Application Publication No. 10-2019-0094238 has disclosed a lanthanide metal-containing precursor including a cyclopentadienyl ligand.

In particular, complex compounds containing cyclopentadienyl groups have lower melting points and higher volatility than compounds containing beta-diketonate or bis(trimethylsilyl)amide and thus are advantageous for use as precursors in thin film formation processes.

For this reason, known technologies, such as Korean Patent No. 10-1660052, Korean Patent Application Publication No. 10-2019-0109142, and Korean Patent Application Publication No. 10-2021-0084297, have proposed chemical structures to which cyclopentadienyl and amidinate ligands are bound, as lanthanide metal-containing precursors. It has been reported that precursors to which these ligands are bound can improve the disadvantages of existing lanthanide metal-based precursors with low vapor pressure and high viscosity, and thus are suitable for use in thin film formation processes.

### Disclosure

### Technical Problem

The present disclosure, which has been devised in view of technologies in the art described above, aims to provide a novel precursor for forming a lanthanide metal-containing thin film, which is capable of exhibiting suitable chemical properties for use as precursors for forming thin films.

In addition, the present disclosure aims to provide a precursor for forming a lanthanide metal-containing thin film, which exhibits chemical properties such as low viscosity, high thermal stability, and high volatility and is a liquid at room temperature or a solid with a low melting point.

In addition, the present disclosure aims to provide a method for forming a thin film using the above precursor.

In addition, the present disclosure aims to provide a semiconductor element including the above thin film.

### Technical Solution

A precursor for forming a lanthanide metal-containing thin film of the present disclosure, which is provided to achieve the objectives as described above, is characterized by including a compound represented by Chemical Formula 1 below.

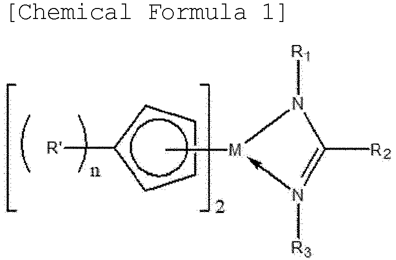

In Chemical Formula 1, M is a lanthanide metal, R₁ and R₃ are each independently a straight-chain, branched-chain, or cyclic alkyl or alkenyl group having 1 to 5 carbon atoms, R₂ is a hydrogen atom or a straight-chain, branched-chain, or cyclic alkyl or alkenyl group having 1 to 4 carbon atoms, each R' is the same or different and is a hydrogen atom or a straight-chain, branched-chain, or cyclic alkyl or alkenyl group having 1 to 4 carbon atoms, and n is an integer in the range of 1 to 5.

In addition, R₂ may be a straight-chain, branched-chain, or cyclic alkyl or alkenyl group having 2 to 4 carbon atoms.

In addition, R₁ and R₃ may each independently be a straight-chain, branched-chain, or cyclic alkyl or alkenyl group having 2 to 5 carbon atoms, and R₂ may be a straight-chain, branched-chain, or cyclic alkyl or alkenyl group having 2 to 4 carbon atoms.

In addition, R₁ and R₃ may be methyl groups.

In addition, R₂ may be an isopropyl group.

In addition, R₁ and R₃ may each independently be a straight-chain alkyl or alkenyl group having 1 to 5 carbon atoms.

In addition, R₁ and R₃ may each independently be a straight-chain alkyl or alkenyl group having 1 to 5 carbon atoms, and R₂ may be a straight-chain alkyl or alkenyl group having 1 to 4 carbon atoms.

In addition, R₁ and R₃ may be both the same and may be alkyl or alkenyl groups.

In addition, R₁ to R₃ may be all the same and may be alkyl or alkenyl groups.

In addition, the precursor for forming the lanthanide metal-containing thin film may have a viscosity of 100 cP or less, which is preferably 80 cP or less and more preferably 60 cP or less.

In addition, the precursor for forming the lanthanide metal-containing thin film may have a melting point of 100°C or lower, which is preferably 80°C or lower and more preferably 60°C or lower.

In addition, the precursor for forming the thin film may further include a solvent, and the solvent may be one or more of a saturated or unsaturated hydrocarbon having 1 to 16 carbon atoms, a ketone, an ether, glyme, an ester, tetrahydrofuran (THF), and a tertiary amine. In addition, the solvent may be included in an amount range of 1 to 99 wt% with respect to the total weight of the precursor for forming the thin film.

A method for forming a lanthanide metal-containing thin film of the present disclosure includes a process of forming a thin film on a substrate using the above precursor for forming the thin film, and the process of forming the thin film on the substrate is characterized by including the following processes: forming a precursor thin film through deposition of the precursor for forming the thin film onto the surface of the substrate, and reacting the precursor thin film with a reactive gas.

In addition, the process of forming the precursor thin film may include a process of vaporizing the precursor for forming the thin film to transfer the resulting vapor of the precursor into a chamber.

In addition, the deposition may be performed by any one process of spin-on dielectric (SOD) deposition, low-temperature plasma (LTP) deposition, chemical vapor deposition (CVD), plasma enhanced chemical vapor deposition (PECVD), high-density plasma chemical vapor deposition (HDPCVD), atomic layer deposition (ALD), or plasma enhanced atomic layer deposition (PEALD).

In addition, the process of forming the lanthanide metal-containing thin film on the substrate may include a step of feeding the precursor for forming the thin film onto the substrate and applying a plasma, thereby forming the thin film.

In addition, a semiconductor element of the present disclosure is characterized by including a thin film manufactured by the above method for forming the lanthanide metal-containing thin film.

### Advantageous Effects

A precursor for forming a lanthanide metal-containing thin film, according to the present disclosure, includes cyclopentadienyl and amidinate ligands, so the precursor compound exhibits excellent structural stability, low viscosity, high volatility, high thermal stability, and properties such as being a liquid at room temperature or a solid with a low melting point. Therefore, the precursor exhibits physical properties suitable for use in a lanthanide metal-containing thin film formation process.

In addition, a high-quality lanthanide metal-containing thin film can be formed using the precursor, and a semiconductor element including such a lanthanide metal-containing thin film, manufactured by the above thin film formation method, can be provided.

### Description of Drawings

FIG. 1 shows ¹H-NMR analysis results of a precursor compound obtained by a preparation method of Example 1.
FIG. 2 shows TGA results of a precursor compound obtained by a preparation method of Example 1.
FIG. 3 shows DSC analysis results of a precursor compound obtained by a preparation method of Example 1.
FIG. 4 shows TGA results of a precursor compound obtained by a preparation method of Example 2.
FIG. 5 shows DSC analysis results of a precursor compound obtained by a preparation method of Example 2.
FIG. 6 shows TGA results of a precursor compound obtained by a preparation method of Example 3.
FIG. 7 shows DSC analysis results of a precursor compound obtained by a preparation method of Example 3.
FIG. 8 shows TGA results of a precursor compound obtained by a preparation method of Example 4.
FIG. 9 shows DSC analysis results of a precursor compound obtained by a preparation method of Example 4.
FIG. 10 shows ¹H-NMR analysis results of a precursor compound obtained by a preparation method of Example 5.
FIG. 11 shows TGA results of a precursor compound obtained by a preparation method of Example 5.
FIG. 12 shows DSC analysis results of a precursor compound obtained by a preparation method of Example 5.
FIG. 13 is a graph showing saturation conditions of a thin film formed using a precursor compound of Example 3, as a function of precursor feeding time.
FIG. 14 is a graph showing changes in thin film thickness as a function of the number of deposition cycles for a thin film formed using a precursor compound of Example 3.
FIG. 15 is a graph showing changes in thin film deposition rates as a function of process temperature for a thin film formed using a precursor compound of Example 3.
FIG. 16 shows XRD analysis results for determining crystallinity of thin films formed using a precursor compound of Example 3 by process temperatures, wherein FIG. 16A shows analysis results of a Gd₂O₃ thin film formed on a Si substrate, and FIG. 16B shows analysis results of a Gd₂O₃ thin film formed on a TiN substrate.
FIG. 17 shows XPS analysis results of a Gd₂O₃ thin film formed on a TiN substrate.
FIG. 18 is a conceptual diagram illustrating a MIM structure in which TiN is deposited as a top electrode onto a Gd₂O₃ thin film formed on a TiN substrate.
FIG. 19 is a graph showing thickness changes of a thin film formed using a precursor compound of Example 2, as a function of the number of process cycles.
FIG. 20 shows XRD analysis results of a CeO₂ thin film formed on a substrate using a precursor compound of Example 2.

### Mode for Invention

Hereinafter, the present disclosure will be described in more detail. All terms or words used in the specification and the appended claims should not be construed as being limited to general and dictionary meanings, but will be interpreted based on the meanings and concepts corresponding to the technical ideas of the present disclosure on the basis of the principle that any inventor is allowed to define the terms appropriately for the best explanation.

A precursor for forming a lanthanide metal-containing thin film, according to the present disclosure, is characterized by including a compound of Chemical Formula 1 below.

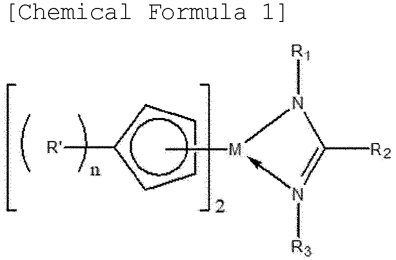

In Chemical Formula **1,** M is a lanthanide metal, R₁ and R₃ are each independently a straight-chain, branched-chain, or cyclic alkyl or alkenyl group having 1 to 5 carbon atoms, R₂ is a hydrogen atom or a straight-chain, branched-chain, or cyclic alkyl or alkenyl group having 1 to 4 carbon atoms, each R' is the same or different and is a hydrogen atom or a straight-chain, branched-chain, or cyclic alkyl or alkenyl group having 1 to 4 carbon atoms, and n is an integer in the range of 1 to 5.

The lanthanide metal refers to 15 elements ranging from the atomic numbers 57, lanthanum (La), to 71, lutetium (Lu), which may include lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu) .

R₁ and R₃ constituting an amidinate ligand in Chemical Formula 1 may be the same or different, which may be configured in various forms depending on the desired effects of the precursor that can be provided through the present disclosure.

In addition, while R₂ constituting the amidinate ligand in Chemical Formula 1 may be a hydrogen atom or a straight-chain, branched-chain, or cyclic alkyl or alkenyl group having 1 to 4 carbon atoms, non-limiting examples thereof may include n-alkyl groups, such as an ethyl group, a propyl group, or a butyl group.

The compound represented by Chemical Formula 1 is a precursor having a chemical structure including the amidinate ligand, in which the lanthanide metal serves as the core metal atom. This precursor includes a cyclopentadienyl ligand providing properties such as a low melting point and high volatility, as well as a novel amidinate ligand having a structure that differs from those in the art. Therefore, high structural stability, low viscosity, high volatility, high thermal stability, and properties such as being a liquid at room temperature or a solid with a low melting point can be added.

In other words, the precursor for forming the lanthanide metal-containing thin film, according to the present disclosure, contains the lanthanide metal as the core metal and includes heterogeneous ligands that provide each of the effects that can contribute to improving the properties of the precursor, especially the novel amidinate ligand that provides structural stability, low viscosity, high volatility, high thermal stability, and excellent effects such as being a liquid at room temperature or a solid with a low melting point. Therefore, the precursor exhibits physical properties suitable for use in a thin film formation process and thus can form a high-quality thin film.

The precursor for forming the thin film, represented by Chemical Formula 1, may have a variety of forms with different functional groups.

In one embodiment, R₂ may be a straight-chain, branched-chain, or cyclic alkyl or alkenyl group having 2 to 4 carbon atoms. When R₂ is provided with 2 or more carbon atoms, the intramolecular asymmetry is increased compared to that in the case of R₂ having 1 carbon atom. Accordingly, the intermolecular interference is reduced. As a result, the ligand-including precursor can facilitate the formation of a liquid or a solid with a low melting point and obtain low-viscosity properties.

In addition, R₁ and R₃ may each independently be a straight-chain, branched-chain, or cyclic alkyl or alkenyl group having 2 to 5 carbon atoms, and R₂ may be a straight-chain, branched-chain, or cyclic alkyl or alkenyl group having 2 to 4 carbon atoms.

In addition, in one embodiment, R₁ and R₃ may be methyl groups, and R₂ may be an isopropyl group.

In addition, R₁ and R₃ may each independently be a straight-chain alkyl or alkenyl group having 1 to 5 carbon atoms.

The molecular weight of straight-chain alkyl or alkenyl groups may be reduced by making ligand structures the smallest compared to those of branched-chain or cyclic groups, thereby obtaining the effects of improving volatility and vapor pressure.

Therefore, in the ligand according to one embodiment of the present disclosure, R₁ and R₃ may each independently be composed of a straight-chain alkyl or alkenyl group. In this case, the ligand-including precursor for forming the thin film has improved vapor pressure, so the effects, such as ease of processing, can be obtained during a thin film formation process using the precursor.

In addition to the effect of improving the vapor pressure, the ligand in which R₁ and R₃ are each independently composed of a straight-chain alkyl group has a high degree of structural freedom of the ligand, so the effect of improving the degree of freedom of the precursor to which the ligand is applied can be obtained. Such an effect allows interference between the precursors to be reduced to a minimum, thus exhibiting the effects of turning the precursor into a liquid and creating low-viscosity properties.

Thus, in the amidinate ligand according to one embodiment of the present disclosure, R₁ and R₃ in Chemical Formula 1 may be composed of straight-chain alkyl or alkenyl groups, in which case the ligand-including precursor may have improved vapor pressure. In addition, through the improvement in the degree of freedom, the formation of a liquid or a solid with a low melting point can be facilitated, and low-viscosity properties can also be obtained.

In addition, R₁ and R₃ may each independently be a straight-chain alkyl or alkenyl group having 1 to 5 carbon atoms, and R₂ may be a straight-chain alkyl or alkenyl group having 1 to 4 carbon atoms.

In addition, R₁ and R₃ may be both the same and may be straight-chain, branched-chain, or cyclic alkyl or alkenyl groups having 1 to 5 carbon atoms.

In addition, R₁ to R₃ may be all the same and may be straight-chain, branched-chain, or cyclic alkyl or alkenyl groups having 1 to 4 carbon atoms.

Exemplary structures of the precursor for forming the thin film, represented by Chemical Formula 1, are as shown below. In the following structures, Ln, a lanthanide metal, refers to 15 elements ranging from the atomic numbers 57, lanthanum (La), to 71, lutetium (Lu), which is selected from lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu).

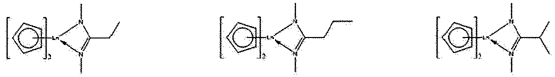

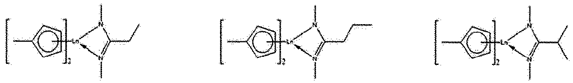

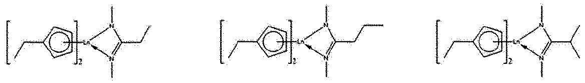

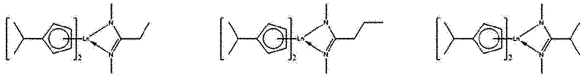

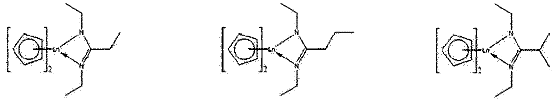

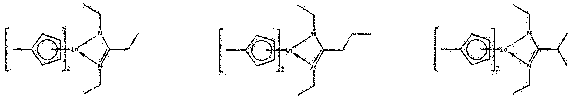

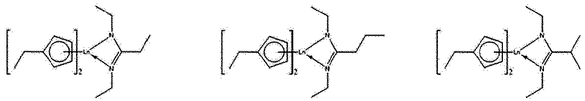

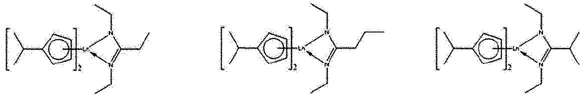

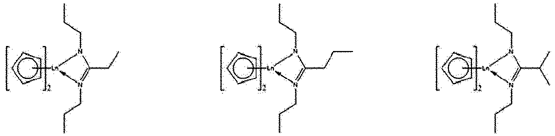

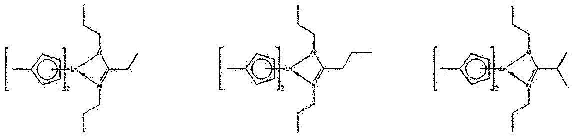

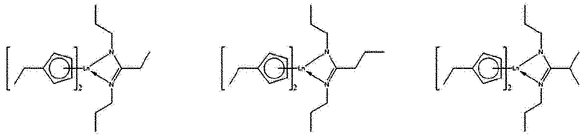

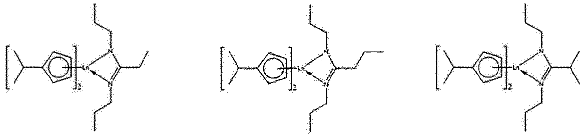

In addition, the cyclopentadienyl ligand has a substituted structure, which allows the control of the molecular size, thus controlling the viscosity and volatility of the precursor compound.

In this case, the precursor for forming the lanthanide metal-containing thin film may have a viscosity of 100 cP or less, which is preferably 80 cP or less and more preferably 60 cP or less. In addition, the precursor for forming the thin film may have a melting point of 100°C or lower, which is preferably 80°C or lower and more preferably 60°C or lower.

The chemical structure of the precursor for forming the thin film enables a liquid precursor with low viscosity, high thermal stability, and high volatility to be obtained, which allows a high-quality thin film to be formed.

In addition, the precursor for forming the thin film of the present disclosure may further include a solvent for dissolving or diluting the precursor compound in consideration of conditions and efficiency of the thin film formation process. As the solvent, any one or a mixture of a saturated or unsaturated hydrocarbon having 1 to 16 carbon atoms, a ketone, an ether, glyme, an ester, THF, and a tertiary amine may be used. Examples of the saturated or unsaturated hydrocarbon having 1 to 16 carbon atoms may include pentane, cyclohexane, ethylcyclohexane, heptane, octane, toluene, and the like, and examples of the tertiary amine may include dimethylethylamine, triethylamine, and the like.

In particular, depending on the chemical structure, the precursor compound for forming the thin film may be a solid at room temperature. In this case, by including the solvent, the compound can be dissolved. In other words, when the solvent is included, the solvent has a content enabling the precursor compound to be dissolved and is preferably included in an amount range of 1 to 99 wt% with respect to the total weight of the precursor for forming the thin film.

The precursors with or without the solvent are vaporizable and thus may be fed into a chamber in the form of precursor gas. Therefore, depending on the types of precursor compounds for forming the thin film, the precursor may be present as a liquid at room temperature and, when being easily vaporizable, the thin film formation process may be performed even without involving additional solvents.

In addition, the process of forming the lanthanide metal-containing thin film may be performed by any one process of SOD deposition, LTP deposition, CVD, PCVD, HDPCVD, ALD, or PALD.

For example, when being applied, the HDPCVD process may be performed at high vacuum and high power compared to an atmospheric pressure chemical vapor deposition (AP-CVD) process, a low-pressure chemical vapor deposition (LP-CVD) process, or a plasma-enhanced chemical vapor deposition (PECVD) process. Therefore, a thin film that is structurally dense and has excellent mechanical properties can be formed.

To this end, a method for forming a thin film, according to the present disclosure, includes a process of forming a thin film on a substrate using the above precursor for forming the thin film.

Specifically, the process of forming the lanthanide-containing thin film on the substrate may include the following processes: forming a precursor thin film through deposition of the precursor for forming the thin film onto the surface of the substrate, and reacting the precursor thin film with a reactive gas.

In addition, for the deposition of the precursor, a process of vaporizing the precursor for forming the thin film to transfer the resulting vapor of the precursor into a chamber may be included.

In addition, the process of forming the lanthanide metal-containing thin film on the substrate may include a process of feeding the precursor for forming the thin film onto the substrate and applying a plasma in the presence of the reactive gas, thereby forming a metal thin film, an oxide thin film, a nitride thin film, an oxynitride thin film, and the like.

The process of forming the thin film may be performed under a condition in an in-chamber pressure range of 1 to 10 Torr. In addition, it is suitable that a source power for forming the plasma in the chamber is in the range of 500 to 9,000 W, and a bias power is in the range of 0 to 5,000 W. In addition, the bias power may not be applied in some cases.

In addition, the process of forming the thin film on the substrate is preferably performed in a temperature range of 150°C to 500°C.

In addition, when feeding the precursor for forming the thin film, a second metal precursor may be introduced as needed to further improve the electrical properties, that is, to improve the capacitance or reduce leakage current values, of the finally formed metal film. As the second metal precursor, a metal precursor including one or more metals (M") selected from magnesium (Mg), strontium (Sr), barium (Ba), lanthanide (Ln), titanium (Ti), zirconium (Zr), hafnium (Hf), niobium (Nb), tantalum (Ta), aluminum (Al), indium (In), silicon (Si), germanium (Ge), and tin (Sn) atoms may further be optionally fed. The second metal precursor may be an alkoxy-based compound or an alkylamide-based compound including the metal described above. For example, when the metal is Si, SiH(N(CH₃)₂)₃, SiH₂(N(C₂H₅)₂)₂, SiH₂(NH^{t}Bu)₂, SiH₃(N(ⁱPr)₂), Si(OC₄H₉)₄, Si(OC₂H₅)₄, Si(OCH₃)₄, Si(OC(CH₃)₃)₄, and the like may be used as the second metal precursor.

The feeding of the second metal precursor may be performed in the same manner as the feeding of the precursor for forming the thin film. In addition, the second metal precursor may be fed onto the substrate for forming the thin film in conjunction with the precursor or may be fed sequentially after the precursor is completely fed.

The precursor for forming the thin film and, optionally, the second metal precursor described above are preferably kept in a temperature range of 50°C to 250°C and are more preferably kept in a temperature range of 100°C to 200°C, before being fed into the reaction chamber, to be brought into contact with the substrate for forming the thin film.

In addition, after the step of feeding the precursor and before feeding the reactive gas, a purge process using an inert gas, such as argon (Ar), nitrogen (N₂), or helium (He), in a reactor may be performed to help the precursor and, optionally, the second metal precursor move onto the substrate or allow for the internal pressure of the reactor suitable for deposition and also to remove impurities from the chamber to the outside. In this case, the purge process using the inert gas is preferably performed so that the internal pressure of the reactor is in the range of 1 to 5 Torr.

In addition, as the reactive gas, any one or a mixture of water vapor (H₂O), oxygen (O₂), ozone (O₃), hydrogen peroxide (H₂O₂), hydrogen (H₂), ammonia (NH₃), nitric oxide (NO), nitrous oxide (N₂O), nitrogen dioxide (NO₂), hydrazine (N₂H₄), and silane (SiH₄) may be used. When the thin film formation process is performed in the presence of oxidizing gases such as water vapor, oxygen, ozone, and the like described above, a metal oxide thin film may be formed. Alternatively, when the thin film formation process is performed in the presence of reducing gases such as hydrogen, ammonia, hydrazine, silane, and the like described above, a pure metal thin film or metal nitride thin film may be formed. In addition, a metal oxynitride thin film may be formed by the combination of the reactive gases.

Furthermore, a treatment process by heat treatment or light irradiation, in addition to plasma treatment, may be performed. This treatment process is intended to provide heat energy for the deposition of the precursor for forming the thin film and may be performed by methods known in the art. Preferably, to manufacture thin films having the desired physical state and composition at a sufficient growth rate, the treatment process above is preferably performed so that the temperature of the substrate in the reactor is in the range of 100°C to 1,000°C and is preferably in the range of 250°C to 600°C.

In addition, even during the treatment process, a purge process using an inert gas, such as argon (Ar), nitrogen (N₂), or helium (He), in a reactor may be performed to help the reactive gas move onto the substrate or allow for the internal pressure of the reactor suitable for deposition and also to remove impurities or byproducts from the reactor to the outside, as described above.

The treatment process involving the feeding of the precursor for forming the thin film, feeding of the reactive gas, and feeding of the inert gas, described above, is considered 1 cycle, and when repeatedly performing 1 or more cycles, the thin film can be formed.

In addition, with the application of the thin film formation process above, various semiconductor elements including the thin film may be manufactured.

The following examples will describe the effects of the precursors of the present disclosure.

### Example 1: Synthesis of bis (ethylcyclopentadienyl) (diethyl-ethylamidinato) lanthanum [(EtCp)₂La(Et₂Et-AMD)]

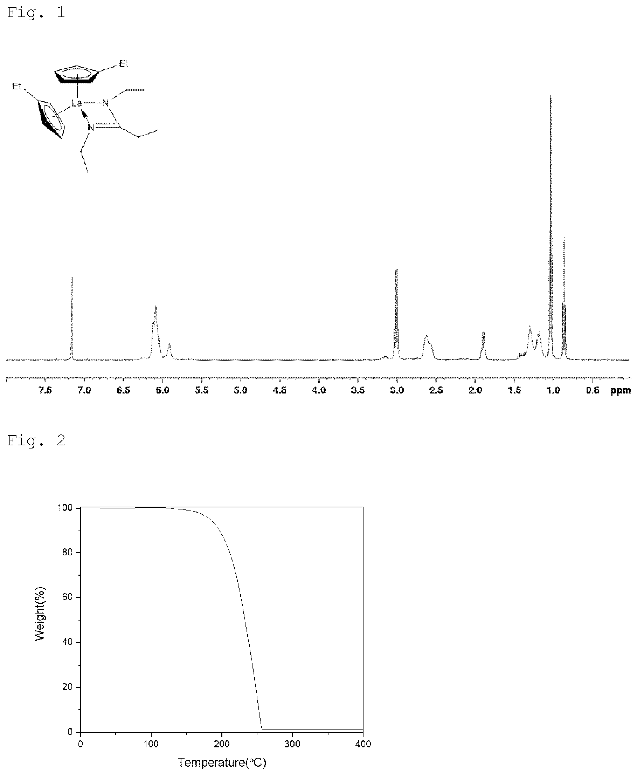

Into 1 L Schlenk flask A, 20.0 g (0.0815 mol) of LaCl₃ and 250 mL of THF were put, and the resulting mixture was stirred for 6 hours. Then, 150 mL of THF and 3.91 g (0.163 mol) of NaH were put into 100 mL Schlenk flask B, and 15.36 g (0.1631 mol) of ethylcyclopentadiene was slowly added dropwise at a temperature of 0°C, followed by stirring the resulting product at room temperature for 12 hours, thereby preparing Na-EtCp. Such prepared Na-EtCp was added to Schlenk flask A at a temperature of 0°C, and the resulting product was stirred at room temperature for 6 hours. THF and 10.46 g (0.0815 mol) of diethyl-ethylamidinate were put into 250 mL Schlenk flask C, and 401.8 mL (1.00 mol) of an n-BuLi hexane solution (2.5 M) was slowly added dropwise at a temperature of 0°C, followed by stirring the resulting product at room temperature for 1 hour. The synthesized Li-(Et₂nPr-AMD) mixture solution was added dropwise to Schlenk flask A at a temperature of 0°C, and the resulting product was stirred at room temperature for 6 hours, followed by removing the solvent under reduced pressure. Such an obtained mixture was extracted with 100 ml of toluene and filtered, thereby evaporating the solvent and volatiles under vacuum. The residual liquid after evaporation was purified by distillation at a temperature of 185°C and a pressure of 44 mTorr, thereby obtaining a pale yellow solid. The yield was 23.14 g (63.0%). The ¹H NMR analysis results are as shown in FIG. 1. The following characteristic peaks were obtained.
¹H NMR (C₆D₆, 25°C): 0.86(t, 3H), 1.04(t, 6H), 1.30 (broad, 6H), 1.89(q, 2H), 2.62(broad, 4H), 3.00(q, 4H), 6.0 (broad, 8H)

During TGA measurement (SDT Q600, purchased from TA instrument) performed at a temperature rise rate of 10°C/min in a nitrogen atmosphere at a flow rate of 200 mL/min, the pale yellow solid had a T_{1/2} value of 232.4°C and a residual mass of 1.2% at a temperature of 350°C, indicating that there were almost no residues left. These results are shown in FIG. 2, which demonstrates TGA results showing the percentage of weight loss as a function of temperature changes.

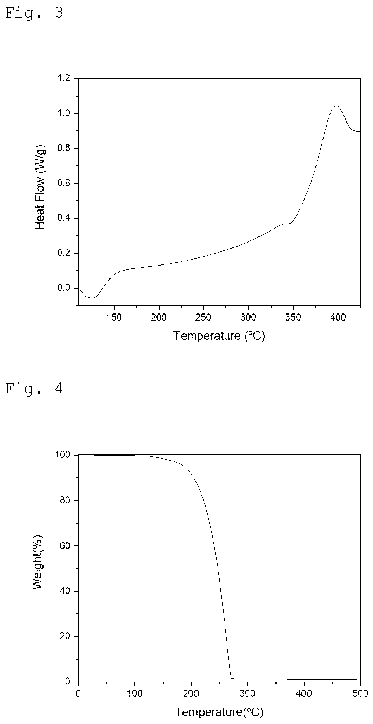

Next, the pale yellow solid sample was placed in a sealed container for DSC and kept under a temperature condition of 40°C for 10 minutes, followed by observing a decomposition peak at a temperature of 400°C during DSC analysis measurement (Discovery 25, purchased from TA instrument) performed at a temperature rise rate of 10°C/min. These results are shown in FIG. 3, which demonstrates DSC analysis results showing heat energy changes as a function of temperature changes.

### Example 2: Synthesis of bis(isopropylcyclopentadienyl)(diethyl-normal-propylamidinato)cerium[(iPrCp)₂Ce(Et₂nPr-AMD)]

Into a 500 mL Schlenk flask, 6.13 g (0.256 mol) of NaH and 140 mL of THF were put, followed by slowly adding 11.54 g (0.081 mol) of diethyl-normal-propylamidinate and 17.56 g (0.162 mol) of isopropylcyclopentadiene dropwise at a temperature of 0°C. The resulting mixture was stirred at room temperature for 12 hours to prepare a mixture solution of Na-EtCp and Na-(Et₂Et-AMD). The Schlenk flask containing the reactants was cooled to a temperature of -10°C, and 20 g (0.081 mol) of cerium chloride was slowly added. The resulting product was stirred at room temperature for 12 hours and then evaporated under vacuum to obtain a liquid, which was then purified by distillation at a temperature of 250°C and a pressure of 50 mTorr, thereby obtaining a dark purple liquid. The yield was 29.5 g (73.4%).

During TGA measurement (SDT Q600, purchased from TA instrument) performed at a temperature rise rate of 10°C/min in a nitrogen atmosphere at a flow rate of 200 mL/min, the dark purple liquid had a T_{1/2} value of 247.4°C and a residual mass of 1.1% at a temperature of 350°C, indicating that there were almost no residues left. These results are shown in FIG. 4, which demonstrates TGA results showing the percentage of weight loss as a function of temperature changes. It was confirmed through the TGA results showing a single volatilization curve that the target compound was synthesized.

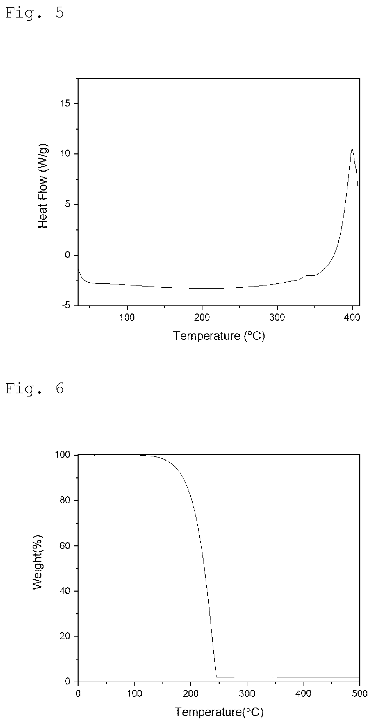

Next, the dark purple liquid sample was placed in a sealed container for DSC and kept under a temperature condition of 40°C for 10 minutes, followed by observing a decomposition peak at a temperature of 399°C during DSC analysis measurement (Discovery 25, purchased from TA instrument) performed at a temperature rise rate of 10°C/min. These results are shown in FIG. 5, which demonstrates DSC analysis results showing heat energy changes as a function of temperature changes.

### Example 3: Synthesis of bis(ethylcyclopentadienyl)(diethyl-ethylamidinato)gadolinium [(EtCp)₂Gd(Et₂Et-AMD)]

Into a 500 mL Schlenk flask, 6.13 g (0.256 mol) of NaH and 140 mL of THF were put, followed by slowly adding 11.54 g (0.081 mol) of diethyl-normal-propylamidinate and 17.56 g (0.162 mol) of isopropylcyclopentadiene dropwise at a temperature of 0°C. The resulting mixture was stirred at room temperature for 12 hours to prepare a mixture solution of Na-EtCp and Na-(Et₂Et-AMD). The Schlenk flask containing the reactants was cooled to a temperature of -10°C, and 20 g (0.081 mol) of gadolinium chloride was slowly added. The resulting product was stirred at room temperature for 12 hours and then evaporated under vacuum to obtain a liquid, which was then purified by distillation at a temperature of 250°C and a pressure of 50 mTorr, thereby obtaining a pale yellow liquid. The yield was 29.5 g (73.4%).

During TGA measurement (SDT Q600, purchased from TA instrument) performed at a temperature rise rate of 10°C/min in a nitrogen atmosphere at a flow rate of 200 mL/min, the pale yellow liquid had a T_{1/2} value of 224°C and a residual mass of 2% at a temperature of 350°C. These results are shown in FIG. 6, which demonstrates TGA results showing the percentage of weight loss as a function of temperature changes. It was confirmed through the TGA results showing a single volatilization curve that the target compound was synthesized.

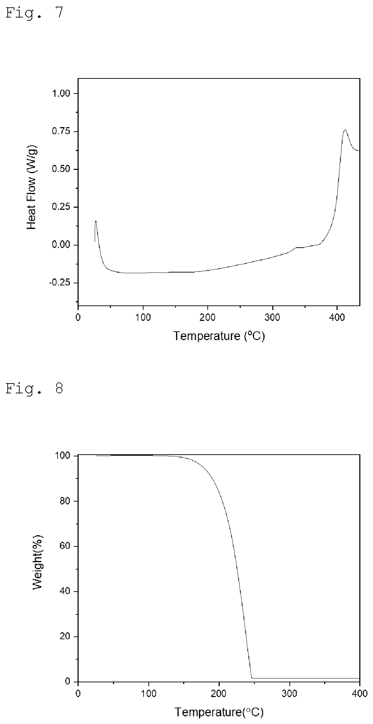

Next, the pale yellow liquid sample was placed in a sealed container for DSC and kept under a temperature condition of 40°C for 10 minutes, followed by observing a decomposition peak at a temperature of 412°C during DSC analysis measurement (Discovery 25, purchased from TA instrument) performed at a temperature rise rate of 10°C/min. These results are shown in FIG. 7, which demonstrates DSC analysis results showing heat energy changes as a function of temperature changes.

Next, the pale yellow liquid was analyzed using a viscometer (DV2T viscometer, purchased from Brookfield Ametek) in a nitrogen atmosphere for viscosity measurement and was confirmed to have a low viscosity of 31 cP at a temperature of 25°C.

### Example 4: Synthesis of bis(ethylcyclopentadienyl) (diethyl-ethylamidinato)dysprosium [(EtCp)₂Dy(Et₂Et-AMD)]

Into a 500 ml Schlenk flask, 160 ml of THF, 9.54 g (0.0744 mol) of diethyl-ethylamidinate, and 14.29 g (0.1489 mol) of ethylcyclopentadiene were put, followed by cooling the resulting mixture to a temperature of 0°C. To the cooled solution, 89.33 mL (0.2233 mol) of an n-BuLi hexane solution (2.5 M) was slowly added dropwise, followed by stirring the resulting mixture at room temperature for 1 hour, to prepare a mixture solution of Li-EtCp and Li-(Et₂Et-AMD). The Schlenk flask containing the reactants was cooled to a temperature of 0°C, and 20 g (0.0744 mol) of dysprosium chloride was added. The resulting product was stirred at room temperature for 3 hours and then evaporated under vacuum to obtain a pale green liquid, which was then purified by distillation under conditions at a temperature of 170°C and a pressure of 58 mTorr, thereby obtaining a pale green liquid. The yield was 19.7 g (55.6%).

During TGA measurement (SDT Q600, purchased from TA instrument) performed at a temperature rise rate of 10°C/min in a nitrogen atmosphere at a flow rate of 200 mL/min, the pale green liquid had a T_{1/2} value of 225.8°C and a residual mass of 1.58% at a temperature of 350°C, indicating that there were almost no residues left. These results are shown in FIG. 8, which demonstrates TGA results showing the percentage of weight loss as a function of temperature changes. It was confirmed through the TGA results showing a single volatilization curve that the target compound was synthesized.

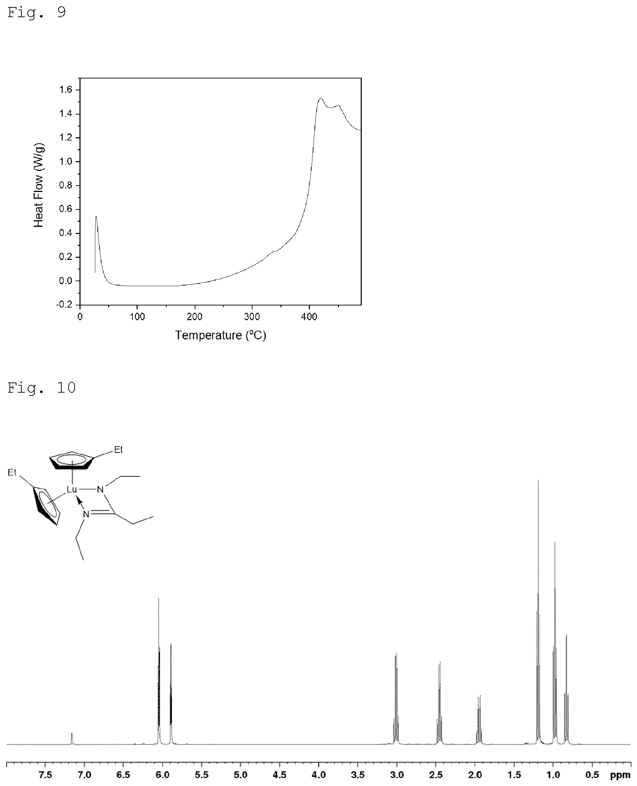

Next, the pale green liquid sample was placed in a sealed container for DSC and kept under a temperature condition of 40°C for 10 minutes, followed by observing a decomposition peak at a temperature of 418°C during DSC analysis measurement (Discovery 25, purchased from TA instrument) performed at a temperature rise rate of 10°C/min. These results are shown in FIG. 9, which demonstrates DSC analysis results showing heat energy changes as a function of temperature changes.

Next, the pale green liquid was analyzed using a viscometer (DV2T viscometer, purchased from Brookfield Ametek) in a nitrogen atmosphere for viscosity measurement and was confirmed to have a low viscosity of 38 cP at a temperature of 25°C.

### Example 5: Synthesis of bis(ethylcyclopentadienyl)(diethyl-ethylamidinato)lutetium [(EtCp)₂Lu(Et₂Et-AMD)]

Into a 500 ml Schlenk flask, 160 ml of THF, 9.12 g (0.0711 mol) of diethyl-ethylamidinate, and 13.39 g (0.1422 mol) of ethylcyclopentadiene were put, followed by cooling the resulting mixture to a temperature of 0°C. To the cooled solution, 85.31 mL (0.2133 mol) of an n-BuLi hexane solution (2.5 M) was slowly added dropwise, followed by stirring the resulting mixture at room temperature for 1 hour, to prepare a mixture solution of Li-EtCp and Li-(Et₂Et-AMD). The Schlenk flask containing the reactants was cooled to a temperature of 0°C, and 20 g (0.0711 mol) of lutetium chloride was added. The resulting product was stirred at room temperature for 3 hours and then evaporated under vacuum to obtain a brown liquid, which was then purified by distillation under conditions at a temperature of 170°C and a pressure of 55 mTorr, thereby obtaining an orange liquid. The yield was 22.4 g (64.5%). The ¹H NMR analysis results are as shown in FIG. 10, and the following characteristic peaks were obtained.
¹H NMR (C₆D₆, 25°C): 0.83(t, 3H), 0.98(t, 6H), 1.19(q, 6H), 1.93(q, 2H), 2.44(q, 4H), 3.00(q, 4H), 6.0(broad, 8H)

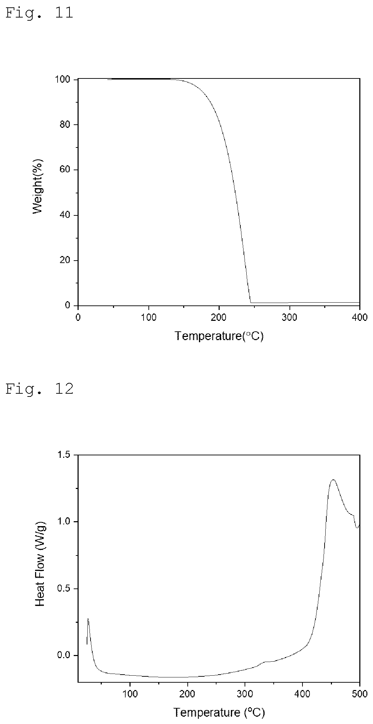

Next, during TGA measurement (SDT Q600, purchased from TA instrument) performed at a temperature rise rate of 10°C/min in a nitrogen atmosphere at a flow rate of 200 mL/min, the orange liquid had a T_{1/2} value of 223°C and a residual mass of 1.4% at a temperature of 350°C, indicating that there were almost no residues left. These results are shown in FIG. 11, which demonstrates TGA results showing the percentage of weight loss as a function of temperature changes.

Next, the orange liquid sample was placed in a sealed container for DSC and kept under a temperature condition of 40°C for 10 minutes, followed by observing a decomposition peak at a temperature of 455°C during DSC analysis measurement (Discovery 25, purchased from TA instrument) performed at a temperature rise rate of 10°C/min. These results are shown in FIG. 12, which demonstrates DSC analysis results showing heat energy changes as a function of temperature changes.

Next, the orange liquid was analyzed using a viscometer (DV2T viscometer, purchased from Brookfield Ametek) in a nitrogen atmosphere for viscosity measurement and was confirmed to have a low viscosity of 38 cP at a temperature of 25°C.

### Preparation Example 1: Thin film formation process using precursor compound of Example 3

Using the precursor compound of Example 3 and O₃ serving as an oxidant, an ALD process was performed by a bubbler system, and film deposition evaluation was performed. The film deposition evaluation was based on changes in thin film thickness as a function of the number of process cycles (number of cycles vs. thickness). The precursor compound of Example 3 was heated to the vaporization temperature, and argon (Ar) gas was then injected through a dip line to generate bubbles so that the vapor of the precursor compound being a gas was fed into a reaction chamber via a carrier gas.

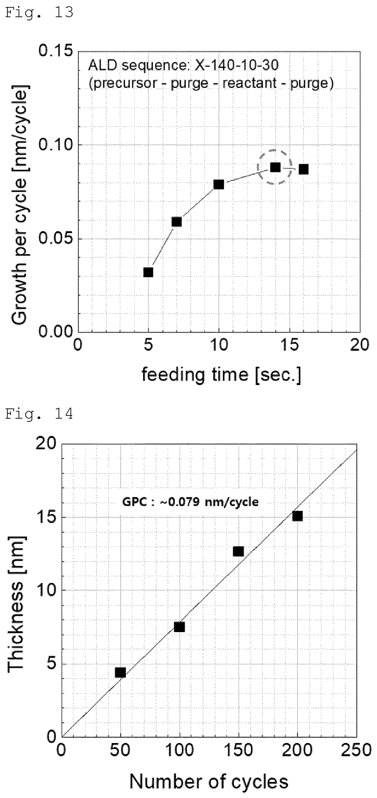

To confirm changes in thin film thickness as a function of the number of process cycles by placing SiO₂ and TiN substrates in the reaction chamber while maintaining a set temperature (300°C), the deposition evaluation was performed by varying the following conditions: precursor feeding time purge time, oxidant feeding time and purge time. The purge process was performed using argon (Ar) gas at a flow rate of 700 sccm, and ozone (O₃), serving as the reactive gas, was injected at a concentration of 220 g/m³. The precursor was heated to a temperature of 100°C while injecting argon serving as the carrier gas at a flow rate of 200 sccm, and saturation conditions for the precursor feeding time under a deposition condition at a temperature of 300°C were confirmed. The results thereof are shown in FIG. 13.

It was confirmed from the results in FIG. 13 that under this process condition, the saturation occurred from 14 seconds of the precursor feeding time.

In addition, to confirm changes in thin film thickness as a function of the number of process cycles, the number of cycles performed was 50, 100, 150, and 200. FIG. 14 shows the results of the changes in thin film thickness as a function of the number of cycles.

It was confirmed through the results in FIG. 14 that the changes in thin film thickness as a function of the number of deposition cycles in the case of the SiO₂ specimen evaluated were uniform, and the growth per cycle (GPC) was confirmed to be about 0.079 nm/cycle.

In addition, to measure changes in thin film deposition rates (ALD window) as a function of process temperatures, the precursor, according to Example 3, was heated to the vaporization temperature, and argon (Ar) gas was then injected through a dip line to generate bubbles so that the vapor of the precursor compound being a gas was fed into a reaction chamber via a carrier gas.

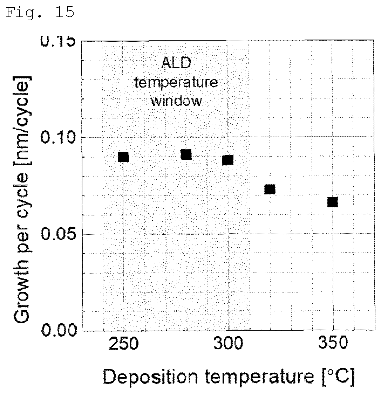

To confirm changes in thin film deposition rates as a function of process temperatures (250°C, 280°C, 300°C, 320°C, and 350°C) by placing SiO₂ and TiN substrates in the reaction chamber while varying temperatures, the following processes were performed in an orderly manner: feeding of the precursor (14 seconds) - purge (140 seconds) - feeding of the oxidant (10 seconds) - purge (30 seconds). The purge process was performed using argon (Ar) gas at a flow rate of 700 sccm. Ozone (O₃), serving as the reactive gas, was injected at a concentration of 220 g/m³. The precursor was heated to a temperature of 100°C while injecting argon serving as the carrier gas at a flow rate of 200 sccm, and the number of process cycles was 50. FIG. 15 shows the results for the changes in thin film deposition rates as a function of the process temperatures.

From the results in FIG. 15, the thin film deposition rates appeared to be similar at about 0.09 nm/cycle at the process temperatures (250°C, 280°C, and 300°C). Through this, it is seen that the process temperature range (ALD window) of the same thin film thickness is obtained. In addition, under the process temperature conditions of 320°C and 350°C, a trend in which the GPC slightly decreased was confirmed.

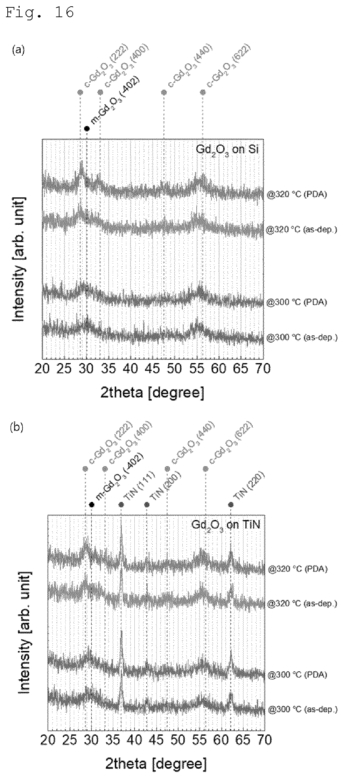

In addition, to confirm thin film crystallinity by process temperatures, XRD analysis was performed on the Gd₂O₃ thin films obtained on the SiO₂ and TiN specimens by process temperatures through the above process evaluation. As a result, the crystallinity of the thin films was confirmed. The crystallinity was measured after the deposition processes at temperatures of 300°C and 320°C, and analysis was also performed on specimens obtained after heat treatment using rapid thermal annealing (RTA) under a N₂ atmosphere condition at a temperature of 600°C for 60 seconds. As a result of the analysis, the crystallinity of Gd₂O₃, in which monoclinic-phase crystallinity and cubic-phase crystallinity were combined, was confirmed by the diffraction patterns measured regardless of the substrate type. Furthermore, it was found that crystallization to the cubic phase was promoted at a temperature of 320°C compared to 300°C. Although changes in crystallinity with the heat treatment were insignificant, it was confirmed that the crystallinity of the sample deposited at a temperature of 320°C was slightly improved after the heat treatment. The analyzed XRD results are shown in FIG. 16.

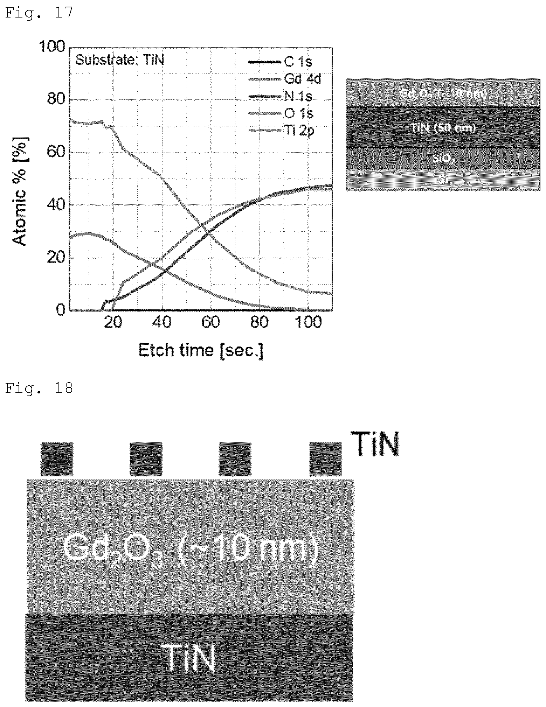

In addition, an XPS depth profile was analyzed to confirm the composition and impurities of the thin film. Through XPS analysis performed on the Gd₂O₃ thin film deposited onto the TiN substrate at a temperature of 300°C, the composition and impurity content of the thin film were confirmed. Both contents of C and N impurities in the thin film were confirmed to be 0%, while the O/Gd content ratio was confirmed to be about 2.5, indicating an oxygen-rich composition ratio. The analyzed results of the XPS depth profile are shown in FIG. 17.

In addition, to evaluate the electrical properties of the thin film, a metal-insulator-metal (MIM) structure was fabricated, as illustrated in FIG. 18, by depositing Gd₂O₃ thin films onto a TiN substrate at temperatures of 300°C and 320°C to a thickness of 10 nm and then depositing TiN as a top electrode.

The results confirming the dielectric constant and leakage current properties of the Gd₂O₃ thin films in such a fabricated element are as shown in Table 1.

**[Table 1]**

| Process temperature | Dielectric constant at 0 V | | Current density [A/cm²] at +0.8 V | | Current density [A/cm²] at -0.8 V | |
|---|---|---|---|---|---|---|
| | As-dep | PDA | As-dep | PDA | As-dep | PDA |
| At 300°C | 14.82 | 13.65 | 7.07 × 10⁻⁹ | 2.47 × 10⁻⁹ | 9.74 × 10⁻⁹ | 3.19 × 10⁻⁹ |
| At 320°C | 13.32 | 12.77 | 1.43 × 10⁻⁸ | 4.25 × 10⁻⁹ | 1.81 × 10⁻⁷ | 1.52 × 10⁻⁸ |

From the above results, it was confirmed that the thin film manufactured above could be used as a thin film capable of improving the properties of dielectric films.

### Preparation Example 2: Thin film formation process using precursor compound of Example 2

Using the precursor of Example 2 and O₃ serving as an oxidant, film deposition evaluation was performed through an ALD process by a bubbler system.

To confirm changes in thin film thickness as a function of the number of process cycles by placing SiO₂ and TiN substrates in a reaction chamber while maintaining a set temperature (280°C), the deposition evaluation was performed under the following conditions: the precursor (40 seconds) - purge (80 seconds) - the oxidant (15 seconds) - purge (30 seconds). The purge process was performed using argon (Ar) gas at a flow rate of 700 sccm, and ozone (O₃), serving as the reactive gas, was injected at a concentration of 200 g/m³. The precursor was heated to a temperature of 110°C while injecting argon serving as the carrier gas at a flow rate of 200 sccm. After setting the temperature of a gas transfer pipe to 120°C, 100 cycles of the process were repeatedly performed to form a Ce-containing thin film.

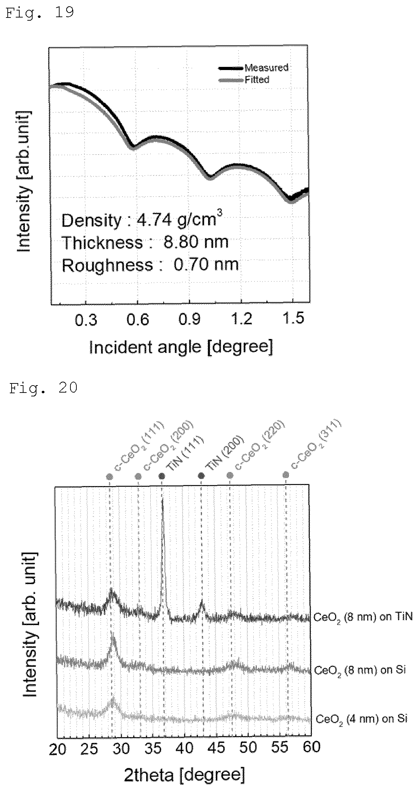

It was confirmed that the thin film formed had a GPC of 0.088 nm/cycle, a density of 4.74 g/cm³, and a good roughness of 0.7 **nm.** The analysis results are shown in FIG. 19.

In addition, as a result of analyzing the crystallinity of the thin film to confirm the properties thereof for use as high-dielectric thin films, it was confirmed that the cubic-phase crystallinity was confirmed regardless of the substrate conditions and, even at a thickness as thin as 4 nm, the cubic-phase crystallinity was found to be exhibited. The analysis results are shown in FIG. 20.

From these results, it was confirmed that the thin film manufactured above could be used as a thin film capable of improving the properties of dielectric films.

The present disclosure has been described above with reference to preferred embodiments but is not limited to these embodiments. Various modifications and changes may be made by those skilled in the art to which the present disclosure belongs without departing from the spirit of the present disclosure. Such modifications and changes should be construed as falling within the scope of the present disclosure and the appended claims.

## Claims

1. A precursor for forming a lanthanide metal-containing thin film, the precursor comprising a lanthanide metal-containing compound represented by Chemical Formula 1 below, 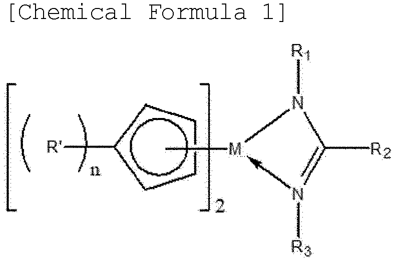 wherein in Chemical Formula 1,
M is a lanthanide metal, R₁ and R₃ are each independently a straight-chain, branched-chain, or cyclic alkyl or alkenyl group having 1 to 5 carbon atoms, R₂ is a hydrogen atom or a straight-chain, branched-chain, or cyclic alkyl or alkenyl group having 1 to 4 carbon atoms, each R' is the same or different and is a hydrogen atom or a straight-chain, branched-chain, or cyclic alkyl or alkenyl group having 1 to 4 carbon atoms, and n is an integer in a range of 1 to 5.

2. The precursor of claim 1, wherein in Chemical Formula 1, R₂ is a straight-chain, branched-chain, or cyclic alkyl or alkenyl group having 2 to 4 carbon atoms.

3. The precursor of claim 1, wherein in Chemical Formula 1, R₁ and R₃ are each independently a straight-chain, branched-chain, or cyclic alkyl or alkenyl group having 2 to 5 carbon atoms, and R₂ is a straight-chain, branched-chain, or cyclic alkyl or alkenyl group having 2 to 4 carbon atoms.

4. The precursor of claim 1, wherein in Chemical Formula 1, R₁ and R₃ are methyl groups.

5. The precursor of claim 1, wherein in Chemical Formula 1, R₂ is an isopropyl group.

6. The precursor of claim 1, wherein in Chemical Formula 1, R₁ and R₃ are each independently a straight-chain alkyl or alkenyl group having 1 to 5 carbon atoms.

7. The precursor of claim 1, wherein in Chemical Formula 1, R₁ and R₃ are each independently a straight-chain alkyl or alkenyl group having 1 to 5 carbon atoms, and R₂ is a straight-chain alkyl or alkenyl group having 1 to 4 carbon atoms.

8. The precursor of claim 1, wherein in Chemical Formula 1, R₁ and R₃ are both the same and are straight-chain, branched-chain, or cyclic alkyl or alkenyl groups having 1 to 5 carbon atoms.

9. The precursor of claim 1, wherein in Chemical Formula 1, R₁ to R₃ are all the same and are straight-chain, branched-chain, or cyclic alkyl or alkenyl groups having 1 to 4 carbon atoms.

10. The precursor of claim 1, wherein the precursor has a viscosity of 100 cP or less.

11. The precursor of claim 1, wherein the precursor has a melting point of 100°C or lower.

12. The precursor of claim 1, further comprising a solvent.

13. The precursor of claim 12, wherein the solvent is one or more of a saturated or unsaturated hydrocarbon having 1 to 16 carbon atoms, a ketone, an ether, glyme, an ester, tetrahydrofuran (THF), and a tertiary amine.

14. The precursor of claim 12, wherein the solvent is included in an amount range of 1 to 99 wt% with respect to the total weight of the precursor.

15. The precursor of claim 1, wherein the precursor is at least one selected from the group consisting of the following structures.

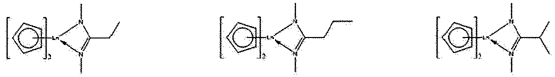

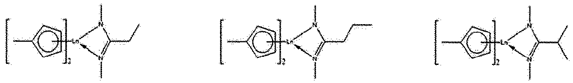

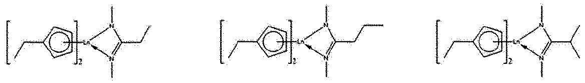

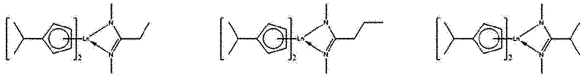

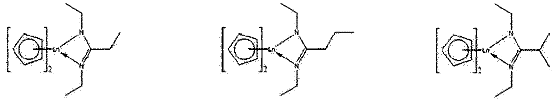

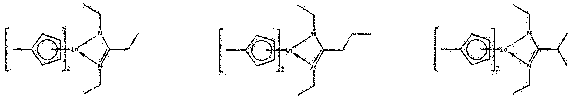

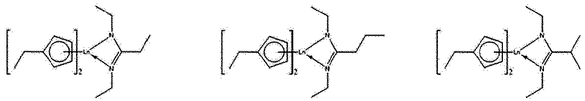

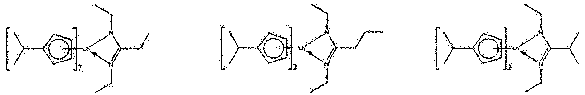

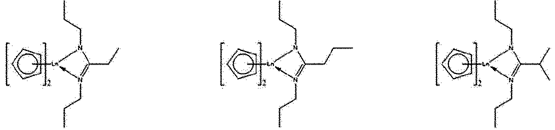

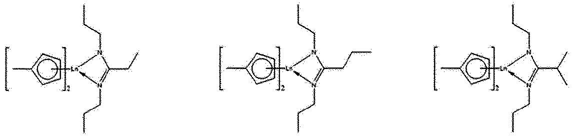

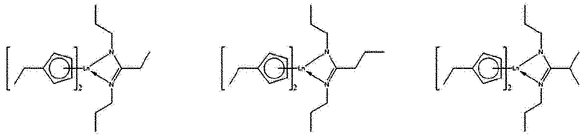

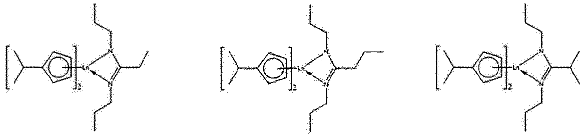

16. A method for forming a lanthanide metal-containing thin film, the method comprising a process of forming a thin film on a substrate using the precursor of claim 1 or 12.

17. The method of claim 16, wherein the process of forming the thin film on the substrate comprises:
a process of forming a precursor thin film through deposition of the precursor onto the surface of the substrate; and
a process of reacting the precursor thin film with a reactive gas.

18. The method of claim 17, wherein the process of forming the precursor thin film comprises a process of vaporizing the precursor to transfer the resulting vapor of the precursor into a chamber.

19. The method of claim 17, wherein the deposition is performed by any one process of spin-on dielectric (SOD) deposition, low-temperature plasma (LTP) deposition, chemical vapor deposition (CVD), plasma enhanced chemical vapor deposition (PECVD), high-density plasma chemical vapor deposition (HDPCVD), atomic layer deposition (ALD), or plasma enhanced atomic layer deposition (PEALD).

20. The method of claim 16, wherein the process of forming the thin film on the substrate comprises feeding the precursor onto the substrate and applying a plasma, thereby forming the thin film.

21. A semiconductor element comprising a lanthanide metal-containing thin film manufactured by the method of claim 16.
